(19) **Europäisches Patentamt / European Patent Office / Office européen des brevets**

(11) **EP 4 764 570 A1**

(12) **EUROPEAN PATENT APPLICATION**
published in accordance with Art. 153(4) EPC

(43) Date of publication:
**24.06.2026 Bulletin 2026/26**

(21) Application number: **25820431.2**

(22) Date of filing: **21.03.2025**

(51) International Patent Classification (IPC):
***G01R 31/396*** (2019.01)  ***G01R 31/382*** (2019.01)
***H01M 10/42*** (2006.01)

(52) Cooperative Patent Classification (CPC):
**G01R 31/382; G01R 31/396; H01M 10/42;**
**Y02E 60/10**

(86) International application number:
**PCT/KR2025/003659**

(87) International publication number:
**WO 2025/254313 (11.12.2025 Gazette 2025/50)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **07.06.2024 KR 20240074592**

(71) Applicant: **LG Energy Solution, Ltd.**
**Seoul 07335 (KR)**

(72) Inventors:
- **KIM, Tae-Hyeon**
  **Daejeon 34122 (KR)**
- **KIM, Hye-Yeong**
  **Daejeon 34122 (KR)**
- **CHOI, Hyun-Jun**
  **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **BATTERY MANAGEMENT APPARATUS AND METHOD**

(57)    A battery management apparatus according to the present disclosure includes a profile obtaining unit configured to obtain a battery profile representing a corresponding relationship between voltage and capacity of a battery; a profile adjusting unit configured to adjust a preset reference positive electrode profile and a reference negative electrode profile to correspond to the battery profile, thereby generating a positive electrode profile and a negative electrode profile of the battery; and a control unit configured to extract a parameter for the battery from at least one of the positive electrode profile and the negative electrode profile and determine an available lithium increase rate of the battery based on the extracted parameter.

FIG. 1

BATTERY MANAGEMENT APPARATUS — 100
PROFILE OBTAINING UNIT — 110
PROFILE ADJUSTING UNIT — 120
CONTROL UNIT — 130
STORAGE UNIT — 140

**Description**

TECHNICAL FIELD

The present disclosure relates to a battery management apparatus and method.

This application is based on and claims priority from Korean Patent Application No. 10-2024-0074592, filed on June 7, 2024, with the Korean Intellectual Property Office, the disclosure of which is incorporated herein in its entirety by reference.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

Although much research is being conducted on these batteries in terms of high capacity and high density, improving lifespan and safety is also important. In order to improve battery safety, a technology that accurately diagnoses the current state of the battery is required.

DISCLOSURE

Technical Problem

The present disclosure is designed to solve the problems of the related art, and therefore the present disclosure is directed to providing a battery management apparatus and method capable of non-destructively diagnosing a state of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

A battery management apparatus according to one aspect of the present disclosure comprises: a profile obtaining unit configured to obtain a battery profile representing a corresponding relationship between voltage and capacity of a battery; a profile adjusting unit configured to adjust a preset reference positive electrode profile and a reference negative electrode profile to correspond to the battery profile, thereby generating a positive electrode profile and a negative electrode profile of the battery; and a control unit configured to extract a parameter for the battery from at least one of the positive electrode profile and the negative electrode profile and determine an available lithium increase rate of the battery based on the extracted parameter.

The control unit may be configured to determine a first feature value from the negative electrode profile and determine the available lithium increase rate of the battery based on the determined first feature value, a preset first reference feature value, a preset reference difference value, and a capacity loss rate of the battery.

The control unit may be configured to calculate a difference between the first reference feature value and the first feature value as a first difference value and determine a value obtained by adding the capacity loss rate to a value, which is obtained by dividing the first difference value by the reference difference value, as the available lithium increase rate.

The control unit may be configured to determine a second feature value and a third feature value from the positive electrode profile and determine the capacity loss rate based on the second feature value, the third feature value, and the reference difference value.

The control unit may be configured to set a charging condition of the battery based on the available lithium increase rate.

The control unit may be configured to determine a second feature value from the positive electrode profile, calculate an available lithium change rate based on the determined second feature value, a preset second reference feature value, and a preset reference difference value, and determine an available lithium loss rate of the battery by adding the calculated available lithium change rate and the available lithium increase rate.

The control unit may be configured to calculate a difference between the second feature value and the second reference feature value as a second difference value and calculate a value obtained by dividing the second difference value by the reference difference value as the available lithium change rate.

The control unit may be configured to compare the available lithium loss rate with a preset threshold value and diagnose a degradation state of the battery based on the comparison result.

The control unit may be configured to set a charging condition of the battery based on the available lithium loss rate.

A battery pack according to another aspect of the present disclosure comprises the battery management apparatus according to one aspect of the present disclosure.

A battery management method according to still another aspect of the present disclosure may comprise: a profile obtaining step of obtaining a battery profile representing a corresponding relationship between voltage and capacity of a battery; a profile adjusting step of adjusting a preset reference positive electrode profile and a reference negative electrode profile to correspond to the battery profile, thereby generating a positive electrode profile and a negative electrode profile; and a diagnosing step of extracting a parameter for the battery from at least one of the positive electrode profile and the negative electrode profile and determining an available lithium increase rate of the battery based on the extracted parameter.

Advantageous Effects

According to one aspect of the present disclosure, the battery management apparatus may non-destructively determine an available lithium increase rate of a battery.

According to one aspect of the present disclosure, the battery management apparatus may non-destructively determine a capacity loss rate of a battery.

According to one aspect of the present disclosure, the battery management apparatus may non-destructively determine an available lithium change rate of a battery.

According to one aspect of the present disclosure, the battery management apparatus may quantitatively distinguish and calculate the available lithium increase rate and available lithium loss rate included in the available lithium change rate, and therefore, may more accurately determine the state of the battery than the prior art.

According to one aspect of the present disclosure, the battery management apparatus may prevent acceleration of structural change of a positive electrode by appropriately setting a charging condition of a battery based on the available lithium increase rate.

According to one aspect of the present disclosure, the battery management apparatus may prevent degradation or accelerated degradation of a battery by appropriately setting a charging condition of the battery based on the available lithium loss rate.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically illustrating a battery management apparatus according to an embodiment of the present disclosure.
FIG. 2 is a schematic diagram illustrating a battery profile and a comparison profile according to an embodiment of the present disclosure.
FIG. 3 is a schematic diagram illustrating a reference positive electrode profile, a reference negative electrode profile, a positive electrode profile, and a negative electrode profile according to an embodiment of the present disclosure.
FIG. 4 is a schematic diagram illustrating a profile obtained by repeatedly charging and discharging a battery according to an embodiment of the present disclosure.
FIG. 5 is a schematic diagram illustrating an available lithium change rate, an available lithium loss rate, and an available lithium increase rate at each diagnosis time point.
FIG. 6 is a drawing illustrating an exemplary configuration of a battery pack including the battery management apparatus according to an embodiment of the present disclosure.
FIG. 7 is a drawing schematically illustrating a vehicle according to still another embodiment of the present disclosure.
FIG. 8 is a drawing schematically illustrating a battery management method according to still another embodiment of the present disclosure.

BEST MODE

Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a most preferred example for the purpose of illustrations only, not intended to limit the scope of the disclosure, so it should be understood that other equivalents and modifications could be made thereto without departing from the scope of the disclosure.

In addition, when explaining the present disclosure, if it is judged that the detailed description of the related known structure or function may obscure the main point of the present disclosure, the detailed description will be omitted.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the attached drawings.

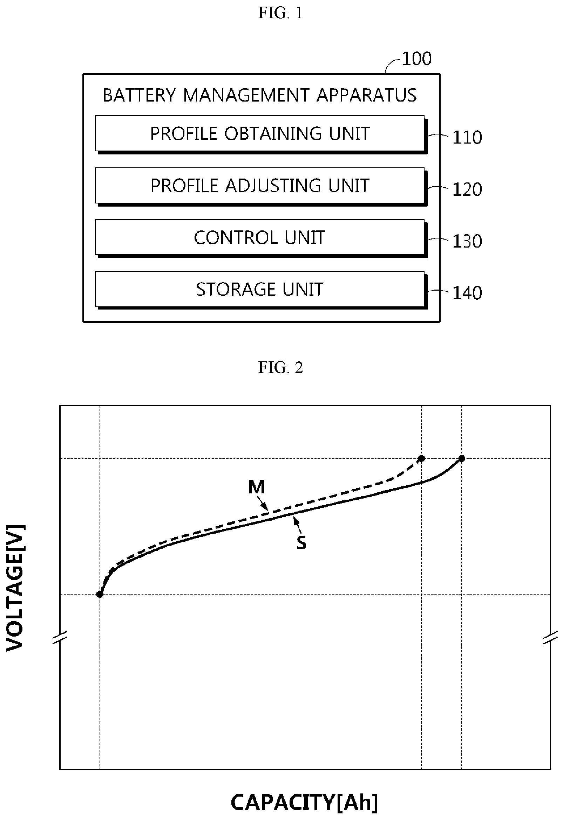

FIG. 1 is a diagram schematically illustrating a battery management apparatus 100 according to an embodiment of the present disclosure.

Referring to FIG. 1, the battery management apparatus 100 may include a profile obtaining unit 110, a profile adjusting unit 120 and a control unit 130.

Here, the battery refers to an independent cell that has a negative electrode terminal and a positive electrode terminal and is physically separable. As an example, a lithium-ion cell or a lithium polymer cell may be considered a battery. Additionally, the type of battery may be cylindrical type, prismatic type, or pouch type. In addition, the battery may mean a battery bank, a battery module, or a battery pack in which a plurality of cells are connected in series and/or parallel. Hereinafter, for convenience of explanation, the battery is explained as meaning one independent cell.

FIG. 2 is a schematic diagram illustrating a battery profile M and a comparison profile S according to an embodiment of the present disclosure.

In the embodiments of FIG. 2, the horizontal axis (X-axis) represents capacity (Ah), and the vertical axis (Y-axis) represents voltage (V).

The profile obtaining unit 110 may be configured to obtain a battery profile M representing a corresponding relationship between the voltage and capacity of the battery.

For example, the battery profile M is a profile representing the corresponding relationship between voltage (V) and capacity (Q) while the SOC (State of Charge) of the battery is charged from a preset charge start SOC or 0% to a preset charge end SOC or 100%. As another example, the battery profile M is a profile representing the corresponding relationship between voltage and capacity while the SOC of the battery is discharged from a preset discharge start SOC or 100% to a preset discharge end SOC or 0%.

For example, there is no special limitation on the C-rate (current rate) in the charge or discharge for generating the battery profile M. However, preferably, the battery should be charged or discharged at a low rate in order to obtain a more accurate battery profile M. This is because when the battery is charged or discharged at a low C-rate, a battery profile M with relatively less overvoltage may be obtained compared to when the battery is charged or discharged at a high C-rate. For example, the battery profile M may be generated in the process of charging or discharging the battery at 0.05 C.

For example, the profile obtaining unit 110 may directly receive a battery profile M from the outside. That is, the profile obtaining unit 110 may receive a profile by being connected to the outside by wire and/or wirelessly. For example, the profile obtaining unit 110 may receive a profile from the outside through a wired communication method such as CAN (Controller Area Network) communication or CAN-FD (CAN with Flexible Data rate) communication. As another example, the profile obtaining unit 110 may receive a profile from the outside through a wireless communication method such as Zigbee, Bluetooth, Wi-Fi, WFD (Wi-Fi Direct), UWB (Ultra-wideband), or mobile communication. Of course, as long as it supports communication between the profile obtaining unit 110 and the outside, the type of the communication protocol is not particularly limited.

As another example, the profile obtaining unit 110 may receive battery information about the voltage and capacity of the battery. Then, the profile obtaining unit 110 may generate a battery profile M based on the received battery information. Specifically, the profile obtaining unit 110 may generate a battery profile M by associating voltage and capacity data included in the received battery information, measured at the same timing, as a corresponding data pair and storing them in a memory or the like.

The profile obtaining unit 110 may be communicatively connected to the profile adjusting unit 120. For example, the profile obtaining unit 110 may be connected to the profile adjusting unit 120 by wire and/or wirelessly. The profile obtaining unit 110 may transmit the obtained profile to the profile adjusting unit 120.

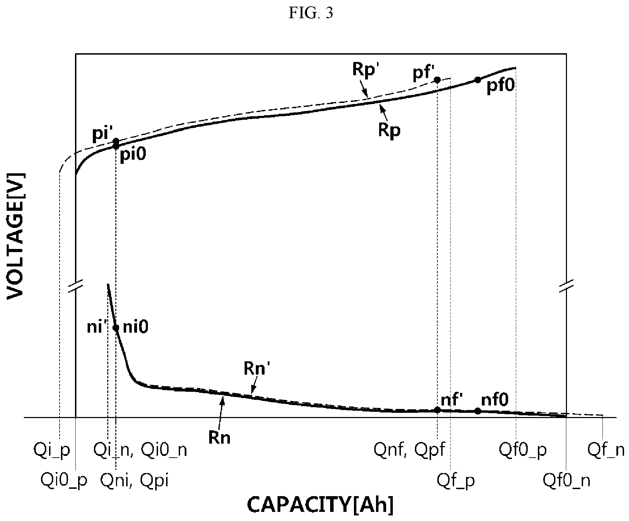

FIG. 3 is a schematic diagram illustrating a reference positive electrode profile Rp, a reference negative electrode profile Rn, a positive electrode profile Rp', and a negative electrode profile Rn' according to an embodiment of the present disclosure.

In the embodiment of FIG. 3, the horizontal axis (X-axis) represents capacity (Ah), and the vertical axis (Y-axis) represents voltage (V).

The profile adjusting unit 120 may be configured to adjust the preset reference positive electrode profile Rp and the reference negative electrode profile Rn to correspond to the battery profile M, thereby generating a positive electrode profile Rp' and a negative electrode profile Rn' of the battery.

Here, the reference positive electrode profile Rp may be a profile representing a corresponding relationship between the voltage and capacity of a reference positive electrode preset to correspond to the positive electrode of the battery. For example, the reference positive electrode may be a positive electrode of a positive electrode coin half cell or a positive electrode of a 3-electrode cell. And, the reference negative electrode profile Rn may be a profile representing a corresponding relationship between the voltage and capacity of a reference negative electrode cell preset to correspond to the negative electrode of the battery. For example, the reference negative electrode may be a negative electrode of a negative electrode coin half cell or a negative electrode of a 3-electrode cell.

Specifically, the profile adjusting unit 120 may adjust the reference positive electrode profile Rp and the reference negative electrode profile Rn to correspond to the battery profile M.

More specifically, the profile adjusting unit 120 may generate an adjustment positive electrode profile and an adjustment negative electrode profile by adjusting the reference positive electrode profile Rp and the reference negative electrode profile Rn, respectively. Here, adjusting the profile may mean performing a shift operation that translates the profile in parallel and/or a scaling operation that enlarges/shrinks the profile.

The profile adjusting unit 120 may generate a comparison profile S from the adjustment positive electrode profile and the adjustment negative electrode profile. For example, the profile adjusting unit 120 may generate the comparison profile S by synthesizing the adjustment positive electrode profile and the adjustment negative electrode profile. Here, synthesizing the profile may mean generating a profile by calculating a difference between two capacity values corresponding to the same voltage value for two profiles, or by calculating a difference between two voltage values corresponding to the same capacity value for two profiles. Preferably, the profile adjusting unit 120 may calculate a difference between two voltage values corresponding to the same capacity value for the adjustment positive electrode profile and the adjustment negative electrode profile, and generate a profile representing a corresponding relationship between the calculated voltage difference and the capacity.

The profile adjusting unit 120 may adjust the reference positive electrode profile Rp and the reference negative electrode profile Rn until the comparison profile S corresponds to the battery profile M. For example, the profile adjusting unit 120 may generate a plurality of comparison profiles S by repeating the adjustment procedure and the synthesis procedure for the reference positive electrode profile Rp and the reference negative electrode profile Rn. The profile adjusting unit 120 may compare each of the plurality of comparison profiles S with the battery profile M in one-to-one relationship, and specify one of the plurality of profiles, which has a minimum error with respect to the battery profile M. The profile adjusting unit 120 may determine the adjustment positive electrode profile used to generate the specified comparison profile S as the positive electrode profile Rp' of the battery. The profile adjusting unit 120 may determine the adjustment negative electrode profile used to generate the specified comparison profile S as the negative electrode profile Rn' of the battery. That is, the adjustment positive electrode profile and adjustment negative electrode profile corresponding to the specific comparison profile S may be estimated as the positive electrode profile Rp' and negative electrode profile Rn' of the battery, respectively.

The control unit 130 may be configured to extract a parameter for the battery from at least one of the positive electrode profile Rp' and the negative electrode profile Rn'.

Parameters may include a first feature point nf', a second feature point pi', a third feature point pf', and a fourth feature point ni'.

Specifically, the positive electrode profile Rp' includes a second feature point pi' corresponding to the positive electrode participation start point pi and a third feature point pf' corresponding to the positive electrode participation end point pf. Here, the positive electrode participation start point pi means a point where the reaction of the positive electrode starts during the charging process or a point where the reaction of the positive electrode ends during the discharging process. The positive electrode participation end point pf means a point where the reaction of the positive electrode ends during the charging process or a point where the reaction of the positive electrode starts during the discharging process. That is, the positive electrode participation start point pi may be a point corresponding to a minimum voltage or a minimum capacity in a range in which the positive electrode reacts. The positive electrode participation end point pf may be a point corresponding to a maximum voltage or a maximum capacity in a range in which the positive electrode reacts.

Similarly, the negative electrode profile Rn' includes a fourth feature value $ni_{MOL}$ corresponding to the negative electrode participation start point ni and a first feature value $nf_{MOL}$ corresponding to the negative electrode participation end point nf. Here, the negative electrode participation start point ni means a point where the reaction of the negative electrode starts during the charging process or a point where the reaction of the negative electrode ends during the discharging process. The negative electrode participation end point nf means a point where the reaction of the negative electrode ends during the charging process or a point where the reaction of the negative electrode starts during the discharging process. That is, the negative electrode participation start point ni may be a point corresponding to a maximum voltage or a maximum capacity in a range in which the negative electrode reacts. The negative electrode participation end point nf may be a point corresponding to a minimum voltage or a minimum capacity in a range in which the negative electrode reacts.

For example, in the embodiment of FIG. 3, the positive electrode profile Rp' may include the second feature point pi' and the third feature point pf'. The negative electrode profile Rn' may include the fourth feature point ni' and the first feature point nf'.

The control unit 130 may extract the second feature point pi' and/or the third feature point pf' from the positive electrode profile as a parameter for the battery. The control unit 130 may extract the fourth feature point ni' and the first feature point nf' from the negative electrode profile Rn' as a parameter for the battery.

The control unit 130 may be configured to determine the available lithium increase rate of the battery based on the extracted parameter.

The available lithium increase rate refers to the rate at which the available lithium amount in the battery increases. That is, the available lithium increase rate refers to the degree to which the amount of lithium ions that may be used for charging and discharging the battery increases. If the available lithium amount increases, the capacity that the battery may express may increase. The available lithium increase rate may indicate how much the available lithium amount in the battery at the diagnosis time point has increased based on the available lithium amount in the BOL (Beginning of Life) state. For example, if the available lithium increase rate is 1%, it means that the available lithium amount in the battery at the diagnosis time point has increased by 1% compared to the available lithium amount in the BOL state.

The battery management apparatus 100 according to an embodiment of the present disclosure may non-destructively determine an available lithium increase rate of a battery.

Meanwhile, the profile obtaining unit 110, the profile adjusting unit 120 and the control unit 130 included in the battery management apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110, the profile adjusting unit 120 and the control unit 130 may be implemented as a set of program modules. At this time, the program module may be stored in the memory and executed by the profile obtaining unit 110, the profile adjusting unit 120 and the control unit 130. The memory may be inside or outside the control unit 130 and may be connected to the control unit 130 by various well-known means.

In addition, the battery management apparatus 100 may further include a storage unit 140. The storage unit 140 may store data necessary for operation and function of each component of the battery management apparatus 100, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

Specifically, the storage unit 140 may store information required for the profile adjusting unit 120 to generate the positive electrode profile Rp' and the negative electrode profile Rn'. For example, the storage unit 140 may store the reference positive electrode profile Rp and the reference negative electrode profile Rn, etc. In addition, the profile adjusting unit 120 may access the storage unit 140 to obtain information required for generating the positive electrode profile Rp' and the negative electrode profile Rn'.

Additionally, the storage unit 140 may store information necessary for the control unit 130 to determine the available lithium increase rate, the available lithium change rate, the available lithium loss rate, and/or the capacity loss rate of the battery. For example, the storage unit 140 may store a first reference feature value, a second reference feature value, a third reference feature value, a fourth reference feature value, and/or a reference difference value. Additionally, the control unit 130 may access the storage unit 140 to obtain information necessary for determining the available lithium increase rate, the available lithium change rate, the available lithium loss rate, and/or the capacity loss rate of the battery.

Below, the first feature value ($nf_{MOL}$), the second feature value ($pi_{MOL}$), the third feature value ($pf_{MOL}$), and the fourth feature value ($ni_{MOL}$) that may be used by the control unit 130 to determine the available lithium increase rate, the available lithium change rate, the available lithium loss rate, or the capacity loss rate of the battery are described.

The first feature value ($nf_{MOL}$) is the SOC of the first feature point nf. Specifically, the first feature value ($nf_{MOL}$) may be determined as the SOC of the first feature point nf of the negative electrode profile Rn'.

For example, the control unit 130 may calculate the ratio of the capacity of the first feature point nf to the capacity of the negative electrode profile Rn' and determine the calculated ratio as the first feature value ($nf_{MOL}$).

Referring to FIG. 3, the entire capacity section of the negative electrode profile Rn' is Qi_n [Ah] to Qf_n [Ah], and the capacity of the first feature point nf is Qnf [Ah]. In this case, the first feature value ($nf_{MOL}$) may be calculated according to the formula of "(Qnf - Qi_n) $\chi$ (Qf_n - Qi_n) X 100".

As another example, the control unit 130 may calculate the ratio of the capacity of the first feature point nf to the capacity of the positive electrode profile Rp' and determine the calculated ratio as the first feature value ($nf_{MOL}$).

As still another example, the control unit 130 may calculate the ratio of the capacity of the first feature point nf to the capacity of the battery profile M, and determine the calculated ratio as the first feature value ($nf_{MOL}$).

The second feature value ($pi_{MOL}$) is the SOC of the second feature point pi'. Specifically, the second feature value ($pi_{MOL}$) may be determined as the SOC of the second feature point pi' of the positive electrode profile Rp'.

For example, the control unit 130 may calculate the ratio of the capacity of the second feature point pi' to the capacity of the positive electrode profile Rp' and determine the calculated ratio as the second feature value ($pi_{MOL}$).

Referring to FIG. 3, the entire capacity section of the positive electrode profile Rp' is Qi_p [Ah] to Qf_p [Ah], and the capacity of the second feature point pi' is Qpi [Ah]. In this case, the second feature value ($pi_{MOL}$) may be calculated according to the formula of "(Qpi - Qi_p) $\chi$ (Qf_p - Qi_p) X 100".

As another example, the control unit 130 may calculate the ratio of the capacity of the second feature point pi' to the capacity of the negative electrode profile Rn' and determine the calculated ratio as the second feature value ($pi_{MOL}$).

As still another example, the control unit 130 may calculate the ratio of the capacity of the second feature point pi' to the capacity of the battery profile M, and determine the calculated ratio as the second feature value ($pi_{MOL}$).

The third feature value ($pf_{MOL}$) is the SOC of the third feature point pf'. Specifically, the third feature value ($pf_{MOL}$) may be determined as the SOC of the third feature point pf' of the positive electrode profile Rp'.

For example, the control unit 130 may calculate the ratio of the capacity of the third feature point pf' to the capacity of the positive electrode profile Rp' and determine the calculated ratio as the third feature value ($pf_{MOL}$).

Referring to FIG. 3, the entire capacity section of the positive electrode profile Rp' is Qi_p [Ah] to Qf_p [Ah], and the capacity of the third feature point pf' is Qpf [Ah]. In this case, the third feature value (pfMOL) may be calculated according to the formula of "(Qpf - Qi_p) $\chi$ (Qf_p - Qi_p) X 100".

As another example, the control unit 130 may calculate the ratio of the capacity of the third feature point pf' to the capacity of the negative electrode profile Rn' and determine the calculated ratio as the third feature value ($pf_{MOL}$).

As still another example, the control unit 130 may calculate the ratio of the capacity of the third feature point pf' to the capacity of the battery profile M, and determine the calculated ratio as the third feature value ($pf_{MOL}$).

The fourth feature value ($ni_{MOL}$) is the SOC of the fourth feature point ni'. Specifically, the fourth feature value ($ni_{MOL}$) may be determined as the SOC of the fourth feature point ni' of the negative electrode profile Rn'.

For example, the control unit 130 may calculate the ratio of the capacity of the fourth feature point ni' to the capacity of the negative electrode profile Rn' and determine the calculated ratio as the fourth feature value ($ni_{MOL}$).

Referring to FIG. 3, the entire capacity section of the negative electrode profile Rn' is Qi_n [Ah] to Qf_n [Ah], and the capacity of the fourth feature point ni' is Qni [Ah]. In this case, the fourth feature value ($ni_{MOL}$) may be calculated according to the formula "(Qni - Qi_n) $\chi$ (Qf_n - Qi_n) X 100".

As another example, the control unit 130 may calculate the ratio of the capacity of the fourth feature point ni' to the capacity of the positive electrode profile Rp' and determine the calculated ratio as the fourth feature value ($ni_{MOL}$).

As still another example, the control unit 130 may calculate the ratio of the capacity of the fourth feature point ni' to the capacity of the battery profile M, and determine the calculated ratio as the fourth feature value ($ni_{MOL}$).

Below, the preset first reference feature value ($nf_{BOL}$), the second reference feature value ($pi_{BOL}$), the third reference feature value ($pf_{BOL}$), the fourth reference feature value ($ni_{BoL}$), and the reference difference value are described.

The reference negative electrode profile Rn includes the first reference feature point (nfD). The first reference feature value ($nf_{BOL}$) is a value representing the SOC of the first reference feature point (nf0).

For example, the control unit 130 may calculate the ratio of the capacity of the first reference feature point (nf0) to the capacity of the reference negative electrode profile Rn, and determine the calculated ratio as the first reference feature value ($nf_{BOL}$).

Referring to FIG. 3, the entire capacity section of the reference negative electrode profile Rn is Qi0_n [Ah] to Qf0_n [Ah], and the capacity of the first reference feature point (nf0) is Qnf0 [Ah]. In this case, the first reference feature value ($nf_{BOL}$) may be calculated according to the formula of "(Qnf0 - Qi0_n) $\chi$ (QfD_n - Qi0_n) X 100". As another example, the control unit 130 may calculate the ratio of the capacity of the first reference feature point (nf0) to the capacity of the reference positive electrode profile Rp, and determine the calculated ratio as the first reference feature value ($nf_{BOL}$). As another example, the control unit 130 may calculate the ratio of the capacity of the first reference feature point (nf0) to the capacity of the reference battery profile M, and determine the calculated ratio as the first reference feature value ($nf_{BOL}$).

The reference battery profile M may be preset based on the reference positive electrode profile Rp and the reference negative electrode profile Rn. Specifically, the reference battery profile M may represent the voltage difference by capacity between the reference positive electrode profile Rp and the reference negative electrode profile Rn.

In the embodiment of FIG. 3, the reference battery profile M may be preset based on the reference positive electrode profile Rp and the reference negative electrode profile Rn. Specifically, the reference battery profile M may represent the voltage difference by capacity between the reference positive electrode profile Rp and the reference negative electrode profile Rn.

The reference positive electrode profile Rp includes the second reference feature point (pi0). The second reference feature value ($pi_{BOL}$) is a value representing the SOC of the second reference feature point (pi0).

For example, the control unit 130 may calculate the ratio of the capacity of the second reference feature point (pi0) to the capacity of the reference negative electrode profile Rn, and determine the calculated ratio as the second reference feature value ($pi_{BOL}$).

Referring to FIG. 3, the entire capacity section of the reference negative electrode profile Rn is Qi0_n [Ah] to Qf0_n [Ah], and the capacity of the second reference feature point (pi0) is Qpi0 [Ah]. In this case, the second reference feature value ($pi_{BOL}$) may be calculated according to the formula of "(Qpi0 - Qi0_n) $\chi$ (Qf0_n - Qi0_n) X 100". As another example, the control unit 130 may calculate a ratio of the capacity of the second reference feature point (pi0) to the capacity of the reference positive electrode profile Rp, and determine the calculated ratio as the second reference feature value ($pi_{BOL}$). As another example, the control unit 130 may calculate a ratio of the capacity of the second reference feature point (pi0) to the capacity of the reference battery profile M, and determine the calculated ratio as the second reference feature value ($pi_{BOL}$).

The reference positive electrode profile Rp includes the third reference feature point (pf0). The third reference feature value ($pf_{BOL}$) is a value representing the SOC of the third reference feature point (pf0).

For example, the control unit 130 may calculate the ratio of the capacity of the third reference feature point (pf0) to the capacity of the reference negative electrode profile Rn, and determine the calculated ratio as the third reference feature value ($pf_{BOL}$).

Referring to FIG. 3, the entire capacity section of the reference negative electrode profile Rn is Qi0_n [Ah] to Qf0_n [Ah], and the capacity of the third reference feature point (pf0) is Qpf0 [Ah]. In this case, the third reference feature value ($pf_{BOL}$) may be calculated according to the formula of "(Qpf0 - Qi0_n) $\chi$ (Qf0_n - Qi0_n) X 100". As another example, the control unit 130 may calculate a ratio of the capacity of the third reference feature point (pf0) to the capacity of the reference positive electrode profile Rp, and determine the calculated ratio as the third feature value ($pf_{BOL}$). As still another example, the control unit 130 may calculate a ratio of the capacity of the third reference feature point (pf0) to the capacity of the reference battery profile M, and determine the calculated ratio as the third reference feature value ($pf_{BOL}$).

The reference negative electrode profile Rn includes the fourth reference feature point (ni0). The fourth reference feature value ($ni_{BOL}$) is a value representing the SOC of the fourth reference feature point (ni0).

For example, the control unit 130 may calculate a ratio of the capacity of the fourth reference feature point (ni0) to the capacity of the reference negative electrode profile Rn, and determine the calculated ratio as the fourth reference feature value ($ni_{BOL}$).

Referring to FIG. 3, the entire capacity section of the reference negative electrode profile Rn is Qi0_n [Ah] to Qf0_n [Ah], and the capacity of the fourth reference feature point (ni0) is Qni0 [Ah]. In this case, the fourth reference feature value ($ni_{BOL}$) may be calculated according to the formula of "(Qni0 - Qi0_n) $\chi$ (Qf0_n - Qi0_n) X 100". As another example, the control unit 130 may calculate a ratio of the capacity of the fourth reference feature point (nf0) to the capacity of the reference positive electrode profile Rp, and determine the calculated ratio as the fourth feature value ($ni_{BOL}$). As still another example, the control unit 130 may calculate a ratio of the capacity of the fourth reference feature point (ni0) to the capacity of the reference battery profile M, and determine the calculated ratio as the fourth reference feature value ($ni_{BOL}$).

The reference difference value ($Diff_{ref}$) may be preset based on the reference positive electrode profile Rp or the reference negative electrode profile Rn. Specifically, the reference difference value ($Diff_{ref}$) may be calculated as the difference between the third reference feature value ($pf_{BOL}$) and the second reference feature value ($pi_{BOL}$). For example, the value obtained by subtracting the second reference feature value ($pi_{BOL}$) from the third reference feature value ($pf_{BOL}$) may be calculated as the reference difference value (i.e., $Diff_{ref} = pf_{BOL} - pi_{BOL}$). Alternatively, the reference difference value ($Diff_{ref}$) may be calculated as the difference between the first reference feature value ($nf_{BOL}$) and the fourth reference feature value ($ni_{BOL}$). For example, the value obtained by subtracting the fourth reference feature value ($ni_{BOL}$) from the first reference feature value ($nf_{BOL}$) may be calculated as the reference difference value (i.e., $Diff_{ref} = nf_{BOL} - ni_{BOL}$). The difference between the third reference feature value ($pf_{BOL}$) and the second reference feature value ($pi_{BOL}$) and the difference between the first reference feature value ($nf_{BOL}$) and the fourth reference feature value ($ni_{BOL}$) may be calculated as the same value. For example, the value obtained by subtracting the second reference feature value ($pi_{BOL}$) from the third reference feature value ($pf_{BOL}$) may be calculated as the reference difference value ($Diff_{ref}$).

Below, a specific embodiment in which the control unit 130 determines the available lithium increase rate of the battery is described.

The available lithium increase rate may be calculated based on the first feature point nf.

The control unit 130 may be configured to determine a first feature value ($nf_{MOL}$) from the negative electrode profile Rn'.

In the embodiment of FIG. 3, the control unit 130 may extract the first feature point nf from the negative electrode profile Rn'. Then, the control unit 130 may determine the first feature value ($nf_{MOL}$) from the first feature point nf. For example, the control unit 130 may determine the SOC of the first feature point nf as the first feature value ($nf_{MOL}$).

The control unit 130 may be configured to determine an available lithium increase rate of the battery based on the determined first feature value ($nf_{MOL}$), the preset first reference feature value ($nf_{BOL}$), the preset reference difference value ($Diff_{ref}$), and the capacity loss rate of the battery.

Specifically, the control unit 130 may be configured to calculate the difference between the first reference feature value ($nf_{BOL}$) and the first feature value ($nf_{MOL}$) as the first difference value.

For example, the control unit 130 may calculate the value obtained by subtracting the first feature value ($nf_{MOL}$) from the first reference feature value ($nf_{BOL}$) as the first difference value (i.e., $nf_{BOL} - nf_{MOL}$).

In addition, the control unit 130 may be configured to determine the value obtained by adding the value, which is obtained by dividing the first difference value by the reference difference value ($Diff_{ref}$), and the capacity loss rate as the available lithium increase rate.

For example, the control unit 130 may calculate the available lithium increase rate using Formula 1 below.

<Formula 1>

$$Add_{Li} = \frac{nf_{BOL} - nf_{MOL}}{Diff_{ref}} + Loss_Q$$

Here, $Add_{Li}$ represents the available lithium increase rate, and $Loss_Q$ represents the capacity loss rate. $nf_{BOL}$ represents the first reference feature value, $nf_{MOL}$ represents the first feature value, and $Diff_{ref}$ represents the reference difference value.

Below, a specific example of determining the capacity loss rate of a battery is described.

The capacity loss rate of a battery refers to the rate at which the capacity of the battery is lost. The capacity loss rate may indicate how much of the capacity of the battery has been lost at the time of diagnosis, based on the capacity of the battery in the BOL state. For example, if the capacity loss rate is 1%, this means that the capacity of the battery at the time of diagnosis has been lost by 1% compared to the capacity of the battery in the BOL state.

For example, the capacity loss rate may be calculated based on the second feature point (pi') and the third feature point (pf).

The control unit 130 may be configured to determine a second feature value ($pi_{MOL}$) and a third feature value ($pf_{MOL}$) from the positive electrode profile.

In the embodiment of FIG. 3, the control unit 130 may determine the second feature point (pi') from the positive electrode profile Rp'. And, the control unit 130 may determine the second feature value ($pi_{MOL}$) from the second feature point (pi'). The control unit 130 may determine the third feature point (pf) from the positive electrode profile Rp'. And, the control unit 130 may determine the third feature value ($pf_{MOL}$) from the third feature point (pf).

In addition, the control unit 130 may be configured to determine the capacity loss rate based on the second feature value ($pi_{MOL}$), the third feature value ($pf_{MOL}$) and the reference difference value ($Diff_{ref}$).

Specifically, the control unit 130 may calculate the difference between the second feature value ($pi_{MOL}$) and the third feature value ($pf_{MOL}$) as the third difference value.

For example, the control unit 130 may calculate the value obtained by subtracting the second feature value ($pi_{MOL}$) from the third feature value ($pf_{MOL}$) as the third difference value.

In addition, the control unit 130 may calculate the value obtained by dividing the third difference value by the reference difference value ($Diff_{ref}$) as the capacity loss rate.

For example, the control unit 130 may calculate the capacity loss rate using Formula 2 below.

<Formula 2>

$$Loss_Q = \frac{pf_{MOL} - pi_{MOL}}{Diff_{ref}}$$

Here, $Loss_Q$ represents the capacity loss rate, $pf_{MOL}$ represents the third feature value, and $pi_{MOL}$ represents the second feature value. $Diff_{ref}$ is the same value as $Diff_{ref}$ in Formula 1 and represents the reference difference value.

As another example, the capacity loss rate may be calculated based on the first feature point (nf) and the fourth feature point (ni').

The control unit 130 may be configured to determine a first feature value ($nf_{MOL}$) and a fourth feature value ($ni_{MOL}$) from the negative electrode profile Rn'.

In the embodiment of FIG. 3, the control unit 130 may determine the first feature point (nf) from the negative electrode profile Rn'. And, the control unit 130 may determine the first feature value ($nf_{MOL}$) from the first feature point (nf). The control unit 130 may determine the fourth feature point (ni') from the negative electrode profile Rn'. And, the control unit 130 may determine the fourth feature value ($ni_{MOL}$) from the fourth feature point (ni').

In addition, the control unit 130 may be configured to determine the capacity loss rate based on the first feature value ($nf_{MOL}$), the fourth feature value ($ni_{MOL}$), and the reference difference value ($Diff_{ref}$).

Specifically, the control unit 130 may calculate the difference between the first feature value ($nf_{MOL}$) and the fourth feature value ($ni_{MOL}$) as the fourth difference value.

For example, the control unit 130 may calculate the value obtained by subtracting the fourth feature value ($ni_{MOL}$) from the first feature value ($nf_{MOL}$) as the fourth difference value.

In addition, the control unit 130 may calculate the value obtained by dividing the fourth difference value by the reference difference value ($Diff_{ref}$) as the capacity loss rate.

For example, the control unit 130 may calculate the capacity loss rate using Formula 3 below.

<Formula 3>

$$Loss_Q = \frac{nf_{MOL} - ni_{MOL}}{Diff_{ref}}$$

Here, $nf_{MOL}$ represents the first feature value, and $ni_{MOL}$ represents the fourth feature value. $Loss_Q$ is the same value as $Loss_Q$ in Formula 2 and represents the capacity loss rate. $Diff_{ref}$ is the same value as $Diff_{ref}$ in Formula 1 and represents the reference difference value.

The battery management apparatus 100 according to an embodiment of the present disclosure may non-destructively determine the capacity loss rate of a battery.

Below, a specific embodiment in which the control unit 130 determines the available lithium change rate of the battery is described.

The available lithium change rate refers to the rate of change in the available lithium amount in the battery. That is, the available lithium change rate refers to the degree to which the amount of lithium ions that may be used for charging and discharging the battery has changed. The available lithium change rate may indicate how much the available lithium amount of the battery has changed at the diagnosis time point based on the available lithium amount of the battery in the BOL state. Preferably, the available lithium change rate may indicate the rate of change in the available lithium amount up to the diagnosis time point to the total available lithium amount at the BOL time point. That is, the available lithium change rate may be calculated as a value obtained by subtracting the available lithium increase rate from the available lithium loss rate.

If the available lithium change rate is positive, it means that the available lithium amount at the diagnosis time point is decreased compared to the available lithium amount of the battery in the BOL state. For example, if the available lithium change rate is 1%, it means that the available lithium amount of the battery at the diagnosis time point is decreased by 1% compared to the available lithium amount of the battery in the BOL state. Conversely, if the available lithium change rate is negative, it means that the available lithium amount at the diagnosis time point is increased compared to the available lithium amount of the battery in the BOL state. For example, if the available lithium change rate is -1%, it means that the available lithium amount of the battery at the diagnosis time point is increased by 1% compared to the available lithium amount of the battery in the BOL state.

The available lithium change rate may be calculated based on the second feature point pi'.

The control unit 130 may be configured to determine a second feature value ($pi_{MOL}$) from the positive electrode profile Rp'.

In the embodiment of FIG. 3, the control unit 130 may determine the second feature point pi' from the positive electrode profile Rp'. And, the control unit 130 may determine the second feature value ($pi_{MOL}$) from the second feature point pi'.

The control unit 130 may be configured to calculate the available lithium change rate based on the determined second feature value ($pi_{MOL}$), the preset second reference feature value ($pi_{BOL}$) and the preset reference difference value ($Diff_{ref}$).

Specifically, the control unit 130 may be configured to calculate the difference between the second feature value ($pi_{MOL}$) and the second reference feature value ($pi_{BOL}$) as the second difference value.

For example, the control unit 130 may calculate the value obtained by subtracting the second reference feature value ($pi_{BOL}$) from the second feature value ($pi_{MOL}$) as the second difference value.

Additionally, the control unit 130 may be configured to calculate the value obtained by dividing the second difference value by the reference difference value ($Diff_{ref}$) as the available lithium change rate.

For example, the control unit 130 may calculate the available lithium change rate using Formula 4 below.

<Formula 4>

$$Total_{Li} = \frac{pi_{MOL} - pi_{BOL}}{Diff_{ref}}$$

Here, $Total_{Li}$ represents the available lithium change rate, $pi_{MOL}$ represents the second feature value, and $pi_{BOL}$ represents the second reference feature value. $Diff_{ref}$ is the same value as $Diff_{ref}$ in Formula 1 and represents the reference difference value.

The battery management apparatus 100 according to an embodiment of the present disclosure may non-destructively determine the available lithium change rate of a battery.

Below, a specific embodiment in which the control unit 130 determines the available lithium loss rate of the battery is described.

The available lithium loss rate refers to the rate at which the available lithium amount of the battery is lost. In other words, the available lithium loss rate refers to the degree to which the amount of lithium ions that may be used for charging and discharging the battery is lost. The available lithium loss rate may indicate how much of the available lithium amount of the battery has been lost at the diagnosis time point based on the available lithium amount of the battery in the BOL state. For example, if the available lithium loss rate is 1%, it means that the available lithium amount of the battery at the diagnosis time point has been lost by 1% compared to the available lithium amount of the battery in the BOL state.

The available lithium loss rate may be calculated based on the available lithium change rate and the available lithium increase rate.

The control unit 130 may be configured to determine the available lithium loss rate of the battery by adding the calculated available lithium change rate and the calculated available lithium increase rate.

For example, the control unit 130 may calculate the available lithium loss rate using Formula 5 below.

<Formula 5>

$$Loss_{Li} = Total_{Li} + Add_{Li}$$

Here, $Loss_{Li}$ represents the available lithium loss rate. $Total_{Li}$ is the available lithium change rate according to Formula 4, and $Add_{Li}$ is the available lithium increase rate according to Formula 1.

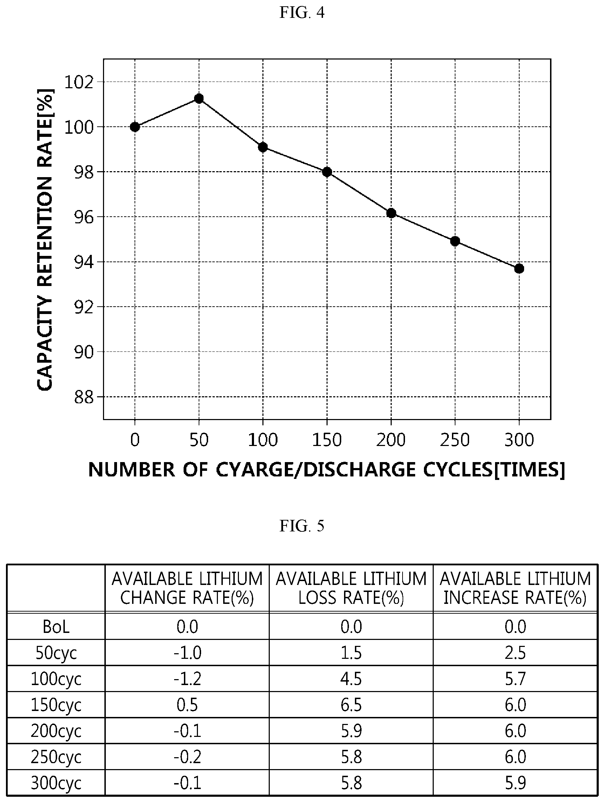

FIG. 4 is a schematic diagram illustrating a profile obtained by repeatedly charging and discharging a battery according to an embodiment of the present disclosure.

In the embodiment of FIG. 4, the horizontal axis (X-axis) represents the number of charge/discharge cycles (times), and the vertical axis (Y-axis) represents the capacity retention rate (SOH, State of Health, %).

Referring to FIG. 4, since the capacity retention rate is determined based on the BOL state, at the BOL time point (e.g., 0 cycle), the capacity retention rate is 100%. In general, when charging and discharging of the battery is repeated or the battery is stored for a long time, the capacity retention rate gradually decreases and shows a value less than 100%. In the embodiment of FIG. 4, it may be confirmed that the capacity retention rate generally decreases as the number of charge/-discharge cycles increases.

One of the causes of the decrease in the capacity retention rate of the battery is the available lithium loss due to the side reaction. Specifically, as the battery is used, a redox reaction (hereinafter, referred to as a side reaction) may occur between the positive electrode and/or the negative electrode and the electrolyte. Here, the side reaction may refer to a reaction caused by the movement of lithium ions (i.e., working ions) between the positive electrode and the electrolyte or between the negative electrode and the electrolyte. More specifically, the positive electrode side reaction may be defined as a reaction in which lithium ions bound to the electrolyte are separated from the electrolyte and move to the positive electrode. In other words, a reaction in which lithium ions separated from the electrolyte diffuse and are intercalated into the positive electrode active material may be defined as the positive electrode side reaction. The negative electrode side reaction may be defined as a reaction in which lithium ions from the negative electrode are combined with the electrolyte. Therefore, the available lithium loss amount may be calculated as the difference between the negative electrode side reaction amount and the positive electrode side reaction amount. Specifically, the value obtained by subtracting the positive electrode side reaction amount from the negative electrode side reaction amount may be calculated as the available lithium loss amount. Alternatively, the available lithium loss rate may be calculated as the difference between the negative electrode side reaction rate and the positive electrode side reaction rate. Specifically, the value obtained by subtracting the positive electrode side reaction rate from the negative electrode side reaction rate may be calculated as the available lithium loss rate.

However, for some batteries, the capacity retention rate may actually increase even as the battery is used. In the example of FIG. 4, it may be confirmed that the capacity retention rate corresponding to 50 cycles exceeds 100%.

The reason why the capacity retention rate increases even though the charge/discharge cycle of the battery increases is because the additional capacity of the battery is expressed. One of the causes of this additional capacity expression is the structural change of the battery electrode. For example, the structural change of the positive electrode may bring about the additional capacity expression of the battery. Specifically, when an active material in which a phase transformation and a redox reaction occur is used in the electrode, an additional capacity of the battery may be expressed. In the initial stage in the use of the battery, the phase transformation and redox reaction of the active material may be gradually activated, and the amount of the reaction may continuously increase until it reaches a certain level.

For example, when a manganese-rich material is used for the positive electrode of a battery, a phase change due to a reaction of lithium manganese oxide (e.g., $Li_2MnO_3$) inside the manganese-rich material and a redox reaction of manganese ions ($O_2^-$) may occur. That is, when a manganese-rich material is used for the positive electrode of a battery, the structure of the positive electrode gradually changes as the battery is used. This change may appear as additional capacity expression of the battery, and the additionally expressed capacity corresponds to an increased available lithium amount.

In the prior art, the available lithium change rate itself was determined as the rate at which the available lithium of the battery was lost. That is, the available lithium loss rate, which is a value related to the degradation of the battery, and the available lithium increase rate, which is a value related to the structural change of the positive electrode, were not distinguished.

FIG. 5 is a schematic diagram illustrating an available lithium change rate, an available lithium loss rate, and an available lithium increase rate at each diagnosis time point.

Since the available lithium change rate was considered as the available lithium loss rate in the prior art, it could be determined that the available lithium has increased by 1.2% compared to the BOL at 100 cycles. According to the present disclosure, the control unit 130 may determine that the available lithium is lost by 4.5% compared to the BOL at 100 cycles due to the side reaction, and the available lithium increases by 5.7% compared to the BOL due to the change in the positive electrode structure. In addition, the control unit 130 may determine that the available lithium increases by a total of 1.2% compared to the BOL at 100 cycles.

Since the battery management apparatus 100 according to an embodiment of the present disclosure may quantitatively distinguish and calculate the available lithium increase rate and the available lithium loss rate included in the available lithium change rate, the state of the battery may be determined more accurately than the prior art.

Below, a specific embodiment is described in which the control unit 130 sets the charging condition of the battery based on the determined available lithium increase rate or available lithium loss rate.

The control unit 130 may be configured to set the charging condition of the battery based on the available lithium increase rate or available lithium loss rate.

Specifically, the control unit 130 may adjust the charge upper limit voltage of the battery. For example, the control unit 130 may reduce the charge upper limit voltage of the battery.

Alternatively, the control unit 130 may adjust the charge upper limit SOC of the battery. For example, the control unit 130 may decrease the charge upper limit SOC of the battery.

Alternatively, the control unit 130 may adjust the charge C-rate range of the battery. For example, the control unit 130 may reduce the upper limit of the charge C-rate of the battery.

The control unit 130 may set the charging condition of the battery based on the available lithium increase rate and the preset first reference value. Here, the first reference value may be the available lithium increase rate determined for the battery in the initial state. Preferably, the first reference value may be the available lithium increase rate determined for the battery in the BOL state. In this case, the first reference value may be 0.

Specifically, the control unit 130 may set the charging condition of the battery based on the difference between the available lithium increase rate and the first reference value. More specifically, the control unit 130 may determine a decrease rate of the charge upper limit voltage to be proportional to the difference between the available lithium increase rate and the first reference value. That is, the larger the difference between the available lithium increase rate and the first reference value, the larger the decrease in the charge upper limit voltage. Here, the decrease rate of the charge upper limit voltage may be calculated based on the preset charge upper limit voltage. Preferably, it may be calculated based on the charge upper limit voltage set for the battery in the BOL state. Alternatively, the control unit 130 may determine a decrease rate of the charge upper limit SOC to be proportional to the difference between the available lithium increase rate and the first reference value. Alternatively, the control unit 130 may determine a decrease rate of the upper limit of the charge C-rate to be proportional to the difference between the available lithium increase rate and the first reference value.

The control unit 130 may set the charging condition of the battery based on the available lithium loss rate and the preset second reference value. Here, the second reference value may be an available lithium loss rate determined for the battery in the initial state. Preferably, the second reference value may be an available lithium loss rate determined for the battery in the BOL state. In this case, the second reference value may be 0.

Specifically, the control unit 130 may set the charging condition of the battery based on the difference between the available lithium loss rate and the second reference value. More specifically, the control unit 130 may determine a decrease rate of the charge upper limit voltage to be proportional to the difference between the available lithium loss rate and the second reference value. That is, the larger the difference between the available lithium loss rate and the second reference value, the larger the decrease in the charge upper limit voltage. Here, the decrease rate of the charge upper limit voltage may be calculated based on the preset charge upper limit voltage. Preferably, it may be calculated based on the charge upper limit voltage set for the battery in the BOL state. Alternatively, the control unit 130 may determine a decrease rate of the charge upper limit SOC to be proportional to the difference between the available lithium loss rate and the second reference value. Alternatively, the control unit 130 may determine a decrease rate of the upper limit of the charge C-rate to be proportional to the difference between the available lithium loss rate and the second reference value.

The battery management apparatus 100 according to an embodiment of the present disclosure may prevent a structural change of a positive electrode from being accelerated by appropriately setting a charging condition of a battery based on an available lithium increase rate.

In addition, the battery management apparatus 100 according to an embodiment of the present disclosure may prevent degradation or accelerated degradation of a battery by appropriately setting a charging condition of the battery based on an available lithium loss rate.

Below, a specific embodiment of diagnosing the degradation state of a battery based on the determined available lithium loss rate by the control unit 130 is described.

The control unit 130 may be configured to compare the available lithium loss rate with a preset threshold value. For example, the control unit 130 may compare the magnitude of the available lithium loss rate with the threshold value.

The control unit 130 may be configured to diagnose the degradation state of the battery based on the comparison result.

If the available lithium loss rate exceeds the threshold value, the control unit 130 may diagnose the state of the battery as a degradation state. Conversely, if the available lithium loss rate is less than or equal to the threshold value, the control unit 130 may diagnose the state of the battery as a normal state.

The battery management apparatus 100 according to the present disclosure may be applied to a battery management system (BMS). That is, the BMS according to the present disclosure may include the battery management apparatus 100 described above. In this configuration, at least some of components of the battery management apparatus 100 may be implemented by supplementing or adding functions of the components included in a conventional BMS. For example, the profile obtaining unit 110, the profile adjusting unit 120 and the control unit 130 of the battery management apparatus 100 may be implemented as components of the BMS.

In addition, the battery management apparatus 100 according to the present disclosure may be provided in the battery pack. That is, the battery pack according to the present disclosure may include the above-described battery management apparatus 100 and at least one battery cell. Additionally, the battery pack may further include electrical components (relays, fuses, etc.) and a case.

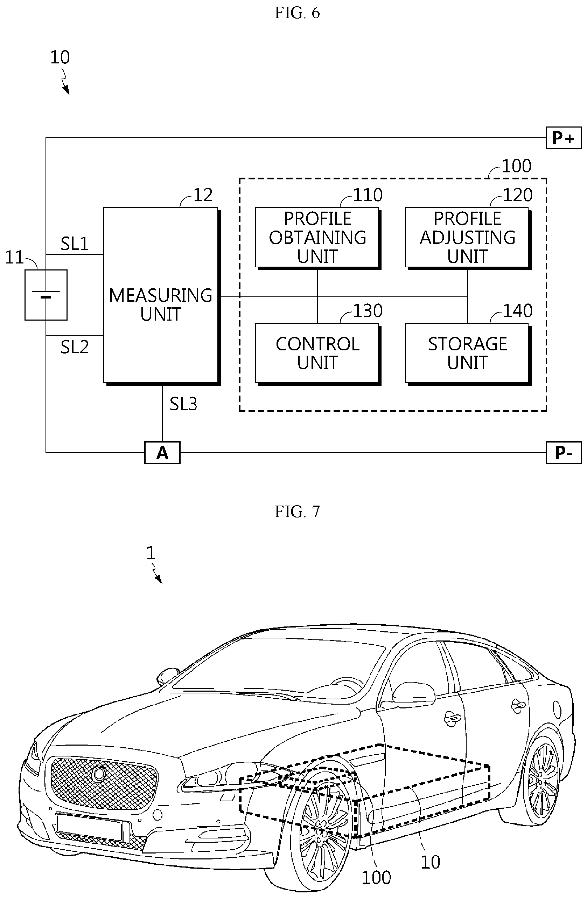

FIG. 6 is a drawing illustrating an exemplary configuration of a battery pack 10 including the battery management apparatus 100 according to an embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to a first sensing line SL1, a second sensing line SL2 and a third sensing line SL3. Specifically, the measuring unit 12 may be connected to the positive electrode terminal of the battery 11 through the first sensing line SL1, and may be connected to the negative electrode terminal of the battery 11 through the second sensing line SL2. The measuring unit 12 may measure the voltage of the battery 11 based on the voltage measured at each of the first sensing line SL1 and the second sensing line SL2.

In addition, the measuring unit 12 may be connected to the current measurement unit A through the third sensing line SL3. For example, the current measurement unit A may be an ammeter or shunt resistor that may measure the charging current and discharging current of the battery 11. The measuring unit 12 may calculate the charging amount by measuring the charging current of the battery 11 through the third sensing line SL3. Additionally, the measuring unit 12 may calculate the discharging amount by measuring the discharging current of the battery 11 through the third sensing line SL3.

One end of a load (not shown) may be connected to the positive electrode terminal P+ of the battery pack 10, and the other end may be connected to the negative electrode terminal P- of the battery pack 10. Therefore, the positive electrode terminal of the battery 11, the positive electrode terminal P+ of the battery pack 10, the load, the negative electrode terminal P- of the battery pack 10, and the negative electrode terminal of the battery 11 may be electrically connected.

For example, the load may be a charging device. As another example, the load may be a motor of an electric vehicle that receives power from the battery 11.

FIG. 7 is a drawing schematically illustrating a vehicle 1 according to still another embodiment of the present disclosure.

Referring to FIG. 7, the battery pack 10 according to an embodiment of the present disclosure may be included in the vehicle 1 such as an electric vehicle (EV) or a hybrid vehicle (HV). Here, the battery pack 10 may be the battery pack 10 described above. Additionally, the battery pack 10 may drive the vehicle 1 by supplying power to the motor through an inverter provided in the vehicle 1. Additionally, the battery pack 10 may include the battery management apparatus 100. That is, the vehicle 1 may include the battery management apparatus 100. In this case, the battery management apparatus 100 may be an on-board device included in the vehicle 1.

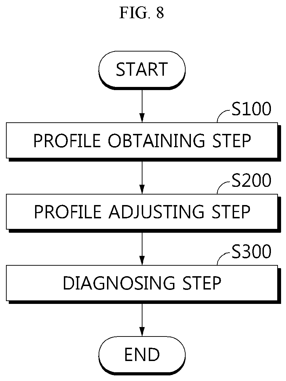

FIG. 8 is a drawing schematically illustrating a battery management method according to still another embodiment of the present disclosure.

Referring to FIG. 8, the battery management method may include a profile obtaining step (S100), a profile adjusting step (S200), and a diagnosing step (S300).

Preferably, each step of the battery management method may be performed by the battery management apparatus 100. Hereinafter, for convenience of explanation, the content overlapping with the previously described content will be briefly described or omitted.

The profile obtaining step (S100) is a step of obtaining a battery profile M representing a corresponding relationship between voltage and capacity of a battery, and may be performed by the profile obtaining unit 110.

The profile adjusting step (S200) is a step of generating a positive electrode profile Rp' and a negative electrode profile Rn' by adjusting a preset reference positive electrode profile Rp and a reference negative electrode profile Rn to correspond to the battery profile M, and may be performed by the profile adjusting unit 120.

The diagnosing step (S300) is a step of extracting a parameter for the battery from at least one of the positive electrode profile Rp' and the negative electrode profile Rn' and determining an available lithium increase rate of the battery based on the extracted parameter, and may be performed by the control unit 130.

The control unit 130 may be configured to determine the available lithium increase rate of the battery based on the extracted parameter.

The available lithium increase rate may be calculated based on the first feature point nf'.

The control unit 130 may be configured to determine a first feature value ($nf_{MOL}$) from the negative electrode profile Rn'.

In the embodiment of FIG. 3, the control unit 130 may extract the first feature point nf from the negative electrode profile Rn'. Then, the control unit 130 may determine the first feature value ($nf_{MOL}$) from the first feature point nf. For example, the control unit 130 may determine the SOC of the first feature point nf as the first feature value ($nf_{MOL}$).

The control unit 130 may be configured to determine an available lithium increase rate of the battery based on the determined first feature value ($nf_{MOL}$), a preset first reference feature value ($nf_{BOL}$), a preset reference difference value ($Diff_{ref}$), and a capacity loss rate of the battery.

Specifically, the control unit 130 may be configured to calculate the difference between the first reference feature value ($nf_{BOL}$) and the first feature value ($nf_{MOL}$) as the first difference value.

For example, the control unit 130 may calculate a value obtained by subtracting the first feature value ($nf_{MOL}$) from the first reference feature value ($nf_{BOL}$) as the first difference value (i.e., $nf_{BOL} - nf_{MOL}$).

Additionally, the control unit 130 may be configured to determine a value obtained by adding the capacity loss rate to the value, which is obtained by dividing the first difference value by the reference difference value ($Diff_{ref}$), as the available lithium increase rate.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

[Explanation of symbols]

1: vehicle
10: battery pack
100: battery management apparatus
110: profile obtaining unit
120: profile adjusting unit
130: control unit
140: storage unit

**Claims**

1. A battery management apparatus, comprising:

   a profile obtaining unit configured to obtain a battery profile representing a corresponding relationship between voltage and capacity of a battery;
   a profile adjusting unit configured to adjust a preset reference positive electrode profile and a reference negative electrode profile to correspond to the battery profile, thereby generating a positive electrode profile and a negative electrode profile of the battery; and
   a control unit configured to extract a parameter for the battery from at least one of the positive electrode profile and the negative electrode profile and determine an available lithium increase rate of the battery based on the extracted parameter.

2. The battery management apparatus according to claim 1,
   wherein the control unit is configured to determine a first feature value from the negative electrode profile and determine the available lithium increase rate of the battery based on the determined first feature value, a preset first reference feature value, a preset reference difference value, and a capacity loss rate of the battery.

3. The battery management apparatus according to claim 2,
   wherein the control unit is configured to calculate a difference between the first reference feature value and the first feature value as a first difference value and determine a value obtained by adding the capacity loss rate to a value, which is obtained by dividing the first difference value by the reference difference value, as the available lithium increase rate.

**4.** The battery management apparatus according to claim 2,
wherein the control unit is configured to determine a second feature value and a third feature value from the positive electrode profile and determine the capacity loss rate based on the second feature value, the third feature value, and the reference difference value.

**5.** The battery management apparatus according to claim 1,
wherein the control unit is configured to set a charging condition of the battery based on the available lithium increase rate.

**6.** The battery management apparatus according to claim 1,
wherein the control unit is configured to determine a second feature value from the positive electrode profile, calculate an available lithium change rate based on the determined second feature value, a preset second reference feature value, and a preset reference difference value, and determine an available lithium loss rate of the battery by adding the calculated available lithium change rate and the available lithium increase rate.

**7.** The battery management apparatus according to claim 6,
wherein the control unit is configured to calculate a difference between the second feature value and the second reference feature value as a second difference value and calculate a value obtained by dividing the second difference value by the reference difference value as the available lithium change rate.

**8.** The battery management apparatus according to claim 6,
wherein the control unit is configured to compare the available lithium loss rate with a preset threshold value and diagnose a degradation state of the battery based on the comparison result.

**9.** The battery management apparatus according to claim 6,
wherein the control unit is configured to set a charging condition of the battery based on the available lithium loss rate.

**10.** A battery pack, comprising the battery management apparatus according to any one of claims 1 to 9.

**11.** A battery management method, comprising:

a profile obtaining step of obtaining a battery profile representing a corresponding relationship between voltage and capacity of a battery;
a profile adjusting step of adjusting a preset reference positive electrode profile and a reference negative electrode profile to correspond to the battery profile, thereby generating a positive electrode profile and a negative electrode profile; and
a diagnosing step of extracting a parameter for the battery from at least one of the positive electrode profile and the negative electrode profile and determining an available lithium increase rate of the battery based on the extracted parameter.

FIG. 1

~100

BATTERY MANAGEMENT APPARATUS

| PROFILE OBTAINING UNIT | ~110 |
| PROFILE ADJUSTING UNIT | ~120 |
| CONTROL UNIT | ~130 |
| STORAGE UNIT | ~140 |

FIG. 2

VOLTAGE[V]

CAPACITY[Ah]

FIG. 3

FIG. 4

FIG. 5

|  | AVAILABLE LITHIUM CHANGE RATE(%) | AVAILABLE LITHIUM LOSS RATE(%) | AVAILABLE LITHIUM INCREASE RATE(%) |
|---|---|---|---|
| BoL | 0.0 | 0.0 | 0.0 |
| 50cyc | -1.0 | 1.5 | 2.5 |
| 100cyc | -1.2 | 4.5 | 5.7 |
| 150cyc | 0.5 | 6.5 | 6.0 |
| 200cyc | -0.1 | 5.9 | 6.0 |
| 250cyc | -0.2 | 5.8 | 6.0 |
| 300cyc | -0.1 | 5.8 | 5.9 |

FIG. 6

FIG. 7

FIG. 8

```
        ┌──────────┐
        │  START   │
        └────┬─────┘
             │
             ▼            ⌐S100
┌────────────────────────────────┐
│    PROFILE OBTAINING STEP       │
└────────────┬───────────────────┘
             │
             ▼            ⌐S200
┌────────────────────────────────┐
│    PROFILE ADJUSTING STEP       │
└────────────┬───────────────────┘
             │
             ▼            ⌐S300
┌────────────────────────────────┐
│      DIAGNOSING STEP            │
└────────────┬───────────────────┘
             │
             ▼
        ┌──────────┐
        │   END    │
        └──────────┘
```

## INTERNATIONAL SEARCH REPORT

| International application No. |
| --- |
| **PCT/KR2025/003659** |

**A. CLASSIFICATION OF SUBJECT MATTER**

**G01R 31/396**(2019.01)i; **G01R 31/382**(2019.01)i; **H01M 10/42**(2006.01)i

According to International Patent Classification (IPC) or to both national classification and IPC

**B. FIELDS SEARCHED**

Minimum documentation searched (classification system followed by classification symbols)

G01R 31/396(2019.01); G01R 19/00(2006.01); G01R 31/367(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 용량(capacity), 프로파일(profile), 가용 리튬(available lithium), 증가율(rate of increase), 손실률(loss rate), 특징값(feature value), 충전 조건(charging condition), 퇴화(degradation)

**C. DOCUMENTS CONSIDERED TO BE RELEVANT**

| Category* | Citation of document, with indication, where appropriate, of the relevant passages | Relevant to claim No. |
| --- | --- | --- |
| Y | KR 10-2021-0146699 A (LG ENERGY SOLUTION, LTD.) 06 December 2021 (2021-12-06) paragraph [0051]; and claim 1 | 1-11 |
| Y | KR 10-2022-0094042 A (LG ENERGY SOLUTION, LTD.) 05 July 2022 (2022-07-05) claim 1 | 1-11 |
| Y | KR 10-2022-0045451 A (LG ENERGY SOLUTION, LTD.) 12 April 2022 (2022-04-12) claim 1 | 2-4,6-9 |
| Y | KR 10-2021-0074001 A (LG ENERGY SOLUTION, LTD.) 21 June 2021 (2021-06-21) paragraph [0205] | 5,9 |
| A | KR 10-2024-0040909 A (LG ENERGY SOLUTION, LTD.) 29 March 2024 (2024-03-29) abstract | 1-11 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **10 July 2025** | **11 July 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/003659**

| Patent document cited in search report | | | Publication date (day/month/year) | Patent family member(s) | | | Publication date (day/month/year) |
|---|---|---|---|---|---|---|---|
| KR | 10-2021-0146699 | A | 06 December 2021 | CN | 114174845 | A | 11 March 2022 |
| | | | | CN | 114174845 | B | 09 April 2024 |
| | | | | EP | 4053573 | A1 | 07 September 2022 |
| | | | | EP | 4053573 | A4 | 07 June 2023 |
| | | | | JP | 2022-545940 | A | 01 November 2022 |
| | | | | JP | 7338101 | B2 | 05 September 2023 |
| | | | | KR | 10-2816638 | B1 | 02 June 2025 |
| | | | | US | 2023-0023014 | A1 | 26 January 2023 |
| | | | | WO | 2021-241886 | A1 | 02 December 2021 |
| KR | 10-2022-0094042 | A | 05 July 2022 | CN | 115398256 | A | 25 November 2022 |
| | | | | EP | 4119963 | A1 | 18 January 2023 |
| | | | | EP | 4119963 | A4 | 22 November 2023 |
| | | | | JP | 2023-515831 | A | 14 April 2023 |
| | | | | JP | 7395808 | B2 | 12 December 2023 |
| | | | | US | 12085623 | B2 | 10 September 2024 |
| | | | | US | 2023-0160970 | A1 | 25 May 2023 |
| | | | | US | 2024-0402259 | A1 | 05 December 2024 |
| | | | | WO | 2022-145777 | A1 | 07 July 2022 |
| KR | 10-2022-0045451 | A | 12 April 2022 | CN | 116057394 | A | 02 May 2023 |
| | | | | EP | 4191262 | A1 | 07 June 2023 |
| | | | | EP | 4191262 | A4 | 27 March 2024 |
| | | | | JP | 2023-536496 | A | 25 August 2023 |
| | | | | JP | 7512514 | B2 | 08 July 2024 |
| | | | | US | 2023-0305065 | A1 | 28 September 2023 |
| | | | | WO | 2022-075708 | A1 | 14 April 2022 |
| KR | 10-2021-0074001 | A | 21 June 2021 | CN | 113853706 | A | 28 December 2021 |
| | | | | CN | 113853706 | B | 15 March 2024 |
| | | | | EP | 4016698 | A1 | 22 June 2022 |
| | | | | EP | 4016698 | A4 | 12 June 2024 |
| | | | | JP | 2022-532120 | A | 13 July 2022 |
| | | | | JP | 7275452 | B2 | 18 May 2023 |
| | | | | US | 11942810 | B2 | 26 March 2024 |
| | | | | US | 12149111 | B2 | 19 November 2024 |
| | | | | US | 2022-0231515 | A1 | 21 July 2022 |
| | | | | US | 2024-0178687 | A1 | 30 May 2024 |
| | | | | WO | 2021-118049 | A1 | 17 June 2021 |
| KR | 10-2024-0040909 | A | 29 March 2024 | CN | 118525214 | A | 20 August 2024 |
| | | | | EP | 4471444 | A1 | 04 December 2024 |
| | | | | KR | 10-2688039 | B1 | 23 July 2024 |
| | | | | WO | 2024-063577 | A1 | 28 March 2024 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240074592